# EUROPEAN PATENT APPLICATION

(11) **EP 4 642 203 A1**
(43) Date of publication of application: **29.10.2025**
(21) Application number: 25167394.3
(22) Date of filing: 31.03.2025
(51) Int. Cl.: H10K 59/124, H10K 59/131

(54) **DISPLAY DEVICE**

(30) Priority: 16.04.2024 KR 20240050780
(71) Applicant: Samsung Display Co., Ltd., Yongin-si, Gyeonggi-do 17113 (KR)
(72) Inventor: CHOI, Deok-Young, 17113 Giheung-Gu, Yongin-si, Gyeonggi-Do (KR); KIM, Mikyung, 17113 Giheung-gu, Yongin-si, Gyeonggi-Do (KR); JUNG, Joohye, 17113 Giheung-gu, Yongin-si, Gyeonggi-Do (KR); CHO, Youngjin, 17113 Giheung-gu, Yongin-si, Gyeonggi-Do (KR)
(74) Representative: Dr. Weitzel & Partner

(57) **Abstract**

A display device includes: a base substrate including a first area, a second area spaced apart from the first area in a first direction, and a third area between the first area and the second area; a pixel in the first area; and a signal line in the first, second, and third areas, the signal line including: a first line portion in the first area; an insulating layer on the first line portion and having a plurality of contact holes defined therethrough; a connection portion on the insulating layer and connected to the first line portion via the contact holes; and a second line portion extending from the first area to the third area and on a different layer from the first line portion, wherein the contact holes are covered by the second line portion and overlap the second line portion in a plan view.

## Description

### BACKGROUND

### 1. Field

The present invention relates to a display device, especially a display device of an electronic device, that is an electronic device with a display device.

### 2. Description of Related Art

A display device includes a display area that is activated in response to electrical signals applied thereto. The display device senses an input applied thereto from the outside through the display area and displays various images to provide information to a user.

The display device includes a display panel and a circuit substrate. The display panel includes a pixel, a signal line connected to the pixel, and a signal pad connected to the signal line.

The above information disclosed in this Background section is only for enhancement of understanding of the background and therefore the information discussed in this Background section does not necessarily constitute prior art.

### SUMMARY

The present invention relates to a display device. The invention is defined by the features of claim 1. Further embodiments of the invention are disclosed in the subclaims and the description.

For example, aspects of some embodiments of the present invention relate to a display device including a signal line.

Aspects of some embodiments of the present invention include a display device including a signal line with relatively improved reliability.

Aspects of some embodiments of the present disclosure include an electronic device comprising a display device including a base substrate including a first area, a second area spaced apart from the first area in a first direction, and a third area between the first area and the second area, a pixel in the first area, and a signal line in the first, second, and third areas. The signal line includes a first line portion in the first area, an insulating layer on the first line portion and provided with a plurality of contact holes defined therethrough, a connection portion on the insulating layer and connected to the first line portion via the contact holes, and a second line portion extending from the first area to the third area and on a different layer from the first line portion. The contact holes are covered by the second line portion and overlap the second line portion in a plan view, that is in a plan view onto the base substrate.

According to some embodiments, the contact holes overlap the first line portion, the connection portion, and the second line portion in a plan view.

According to some embodiments, the display device further includes an organic layer between the connection portion and the second line portion. According to some embodiments, the organic layer is provided with a first organic layer opening through which the connection portion is exposed, and the second line portion is directly on an upper surface of the connection portion exposed through the first organic layer opening.

According to some embodiments, the first organic layer opening overlaps all the contact holes in a plan view, and the first organic layer opening is inside the connection portion and extends to an area where the first line portion is not located in a plan view.

According to some embodiments, the first organic layer opening does not overlap all the contact holes in a plan view, and the first organic layer opening surrounds an area where the contact holes are located in a plan view. In other words, the first organic layer opening may have a closed ring form, in the plan view onto the base substrate, for example in the form of an area between two concentric rectangles, surrounding the area where the contact holes are located. Especially, the first organic layer opening does not overlap any of the contact holes in the plan view. Does not overlap means in a positive definition that the first organic layer opening is free of an overlap with some or any of the contact holes.

According to some embodiments, the first organic layer opening overlaps some of the contact holes in a plan view. The first organic layer opening may overlap only some of the contact holes in the plan view.

For example, according to an embodiment, the first organic layer opening may have a closed ring form, in the plan view onto the base substrate, for especially essentially in the form of an area between two concentric rectangles surrounding the area where the contact holes are located, but with an inner protrusion overlapping one or some of the contact holes in the plan view. According to another exemplary embodiment, the first organic layer opening may have a closed ring form, in the plan view onto the base substrate, for especially essentially in the form of an area between two concentric rectangles surrounding the area where the contact holes are located, but with an inner part bridging the area with the contact holes enclosed by the area between two concentric rectangles and overlapping some of the contact holes in the plan view.

According to some embodiments, the first organic layer opening does not overlap all the contact holes in a plan view, the organic layer includes a first portion that overlaps the contact holes and a second portion that overlaps the connection portion and does not overlap the first line portion, and the first portion and the second portion of the organic layer are provided integrally with each other. Especially, the first organic layer opening does not overlap any of the contact holes in the plan view.

According to some embodiments, the first organic layer opening is inside the connection portion and the first line portion in a plan view.

According to some embodiments, the organic layer is further provided with a second organic layer opening defined therethrough to be spaced apart from the first organic layer opening and not to overlap the first line portion.

According to some embodiments, the second organic layer opening is inside the connection portion and the second line portion in a plan view.

According to some embodiments, the first line portion includes molybdenum (Mo).

According to some embodiments, the connection portion includes aluminum (Al).

According to some embodiments, the first area includes a display area in which the pixel is located and a first non-display area adjacent to the display area, and the first line portion is in the first non-display area.

According to some embodiments, the second area includes a pad, and the second line portion is connected to the pad.

According to some embodiments, the third area is bent with respect to an imaginary axis extending in a second direction intersecting the first direction.

According to some embodiments, the second line portion includes a contact portion overlapping the first line portion and a plurality of line portions extending from the contact portion and overlapping the third area, and the line portions extend in the first direction and are arranged in a second direction intersecting the first direction.

According to some embodiments, the display device further includes a scan driving circuit in the first area and applying a scan signal to the pixel, and the signal line is connected to the scan driving circuit.

According to some embodiments, the signal line is connected to the pixel.

According to some embodiments, the insulating layer includes a plurality of inorganic layers.

Aspects of some embodiments of the present invention include an electronic device comprising a display device including a base substrate including a first area, a second area spaced apart from the first area in a first direction, and a third area between the first area and the second area, a pixel in the first area, and a signal line in the first, second, and third areas. According to some embodiments, the signal line includes a first line portion in the first area, an insulating layer on the first line portion and provided with a plurality of contact holes defined therethrough, a connection portion on the insulating layer and connected to the first line portion via the contact holes, and a second line portion extending from the first area to the third area and on a different layer from the first line portion. According to some embodiments, at least a portion of the connection portion overlaps both the first line portion and the second line portion in a plan view.

According to the above, the signal line of the display device has a structure that may be able to prevent or reduce corrosion caused by moisture penetration, and thus, the reliability of the display device may be relatively improved.

### BRIEF DESCRIPTION OF THE DRAWINGS

The above and other aspects of some embodiments of the present invention will become more apparent by reference to the following detailed description when considered in conjunction with the accompanying drawings wherein:
FIGS. 1A and 1B are perspective views of a display device according to some embodiments of the present invention;
FIG. 2 is a cross-sectional view of a display device according to some embodiments of the present invention;
FIG. 3 is a plan view of a display panel according to some embodiments of the present invention;
FIGS. 4 and 5 are cross-sectional views of a display device according to some embodiments of the present invention;
FIG. 6A is a plan view of a signal line according to some embodiments of the present invention;
FIGS. 6B and 6C are cross-sectional views of a signal line according to some embodiments of the present invention;
FIG. 7A is a plan view of a signal line according to some embodiments of the present invention;
FIGS. 7B and 7C are cross-sectional views of a signal line according to some embodiments of the present invention;
FIG. 8A is a plan view of a signal line according to some embodiments of the present invention;
FIG. 8B is a cross-sectional view of a signal line according to some embodiments of the present invention;
FIG. 9A is a plan view of a signal line according to some embodiments of the present invention;
FIG. 9B is a cross-sectional view of a signal line according to some embodiments of the present invention;
FIG. 10A is a plan view of a signal line according to some embodiments of the present invention; and
FIG. 10B is a cross-sectional view of a signal line according to some embodiments of the present invention.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present invention. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present invention will be described in more detail with reference to accompanying drawings.

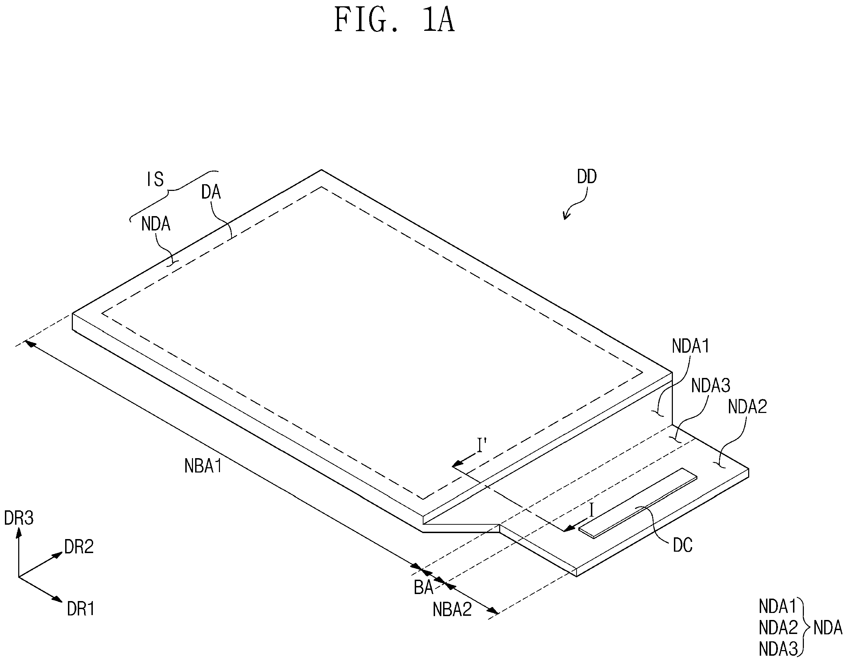

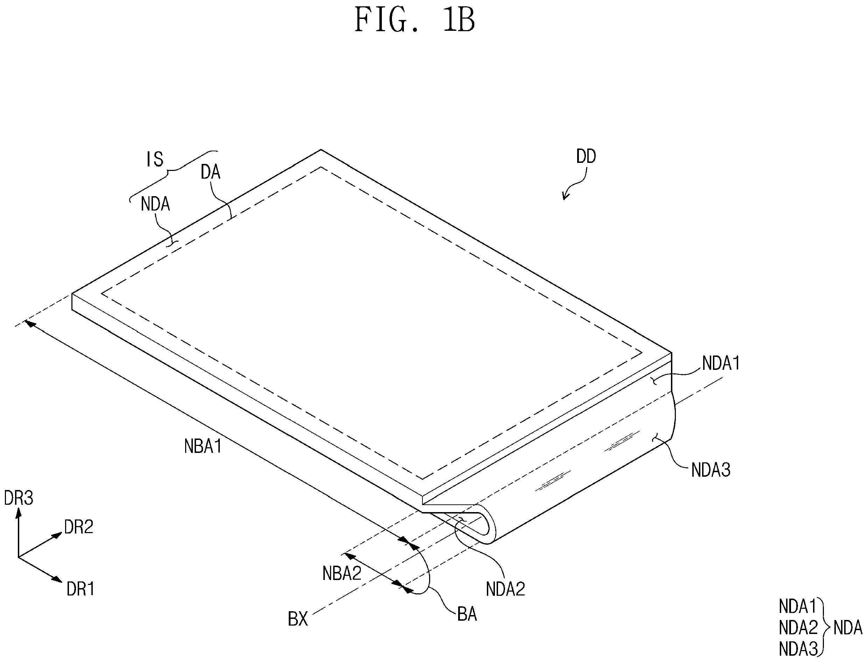

FIGS. 1A and 1B are perspective views of a display device DD according to some embodiments of the present invention. FIG. 1A shows a non-bending state of a bending area BA of the display device DD. FIG. 1B shows a bending state of the bending area BA of the display device DD.

Referring to FIGS. 1A and 1B, a mobile phone terminal is shown as a representative example of the display device DD. The display device DD according to some embodiments of the present invention may be applied to a large-sized electronic device, such as a television set, a monitor, etc., and a small and medium-sized electronic device, such as a tablet computer, a car navigation unit, a game unit, a smart watch, etc.

The display device DD may have a rectangular shape with long sides extending in a first direction DR1 and short sides extending in a second direction DR2 intersecting the first direction DR1. However, the shape of the display device DD should not be limited to the rectangular shape, and the display device DD may have a variety of shapes, such as a circular shape, a polygonal shape, etc. According to some embodiments, the display device DD may have rounded corners.

Hereinafter, a direction perpendicular (or substantially perpendicular) to a plane defined by the first direction DR1 and the second direction DR2 may be referred to as a third direction DR3. In the present disclosure, the phrases "when viewed in a plane" or "in a plan view" refers to a state of being viewed in the third direction DR3 or in a direction toward a display surface of the display device DD.

The display device DD may be rigid or flexible. The term "flexible" used herein refers to the property of being able to be bent, and the display device DD may include all structures from a structure that is completely bent to a structure that is bent at the scale of a few nanometers. For example, the flexible display device DD may be a curved display device, a rollable display device, or a foldable display device.

The display device DD may display images at a display surface IS. The display surface IS may be parallel (or substantially parallel) to the plane defined by the first direction DR1 and the second direction DR2. The display surface IS may include a display area DA at which images are displayed and a non-display area NDA adjacent to (e.g., in a periphery or outside a footprint of) the display area DA. The images may not be displayed through the non-display area NDA. According to some embodiments, the non-display area NDA may be located adjacent to only one side of the display area DA or may be omitted.

The display device DD may include a window, a display module, and an accommodation member.

The window may be located on the display module and may transmit a light provided from the display module to the outside thereof. The window may include a base layer and functional layers located on the base layer. The functional layers may include a protective layer, an anti-fingerprint layer, etc. The base layer of the window may include glass, sapphire, or plastic. The base layer of the window may include an optically transparent insulating material. As an example, the base layer of the window may include a glass or plastic film or may include a glass substrate and a plastic film attached to the glass substrate by an adhesive.

The window may include a transmissive area and a non-transmissive area. The transmissive area may overlap the display area DA and may have a shape corresponding to the display area DA. The non-transmissive area may overlap the non-display area NDA and may have a shape corresponding to the non-display area NDA. The non-transmissive area may have a relatively low light transmittance compared with the transmissive area. The non-transmissive area may be defined in a portion of the base layer of the window by a bezel pattern, and an area where the bezel pattern is not located may be defined as the transmissive area. However, embodiments according to the present invention are not limited thereto or thereby, and according to some embodiments, the non-transmissive area may be omitted.

The accommodation member may accommodate the display module and may be coupled with the window.

The display device DD may further include a circuit board, a main board, and modules, such as electronic modules, a camera module, and a power module, mounted on the main board.

The display device DD may include a first non-bending area NBA1 (hereinafter, referred to as a first area), a second non-bending area NBA2 (hereinafter, referred to as a second area) spaced apart from the first non-bending area NBA1 in the first direction DR1, and a bending area BA (hereinafter, referred to as a third area) defined between the first non-bending area NBA1 and the second non-bending area NBA2.

The first area NBA1 may include the display area DA and a portion (hereinafter, referred to as a first non-display area NDA1) of the non-display area NDA. The second area NBA2 may include another portion (hereinafter, referred to as a second non-display area NDA2) of the non-display area NDA, which is spaced apart from the first non-display area NDA1 in the first direction DR1. The third area BA may include an area (hereinafter, referred to as a third non-display area NDA3) between the first non-display area NDA1 and the second non-display area NDA2.

The third area BA may be bent along a bending axis BX extending in the second direction DR2. The third area BA and the second area NBA2 may have a width smaller than a width of the first area NBA1 in the second direction DR2. A driving chip DC may be mounted in the second area NBA2, however, embodiments according to the present invention are not limited thereto or thereby. According to some embodiments, the driving chip DC may be mounted on the circuit board, and the circuit board may be electrically connected to the second area NBA2.

As the third area BA is bent, the second area NBA2 may be arranged to face the first area NBA1, and thus, a size of the non-display area NDA in the display surface IS may be relatively reduced. Referring to the display device DD of FIG. 1B, the size of the non-display area NDA may be reduced by at least the second area NBA2 when compared with the display device DD shown in FIG. 1A. As described above, as the third area BA is bent, a bezel area of the display device DD may be reduced.

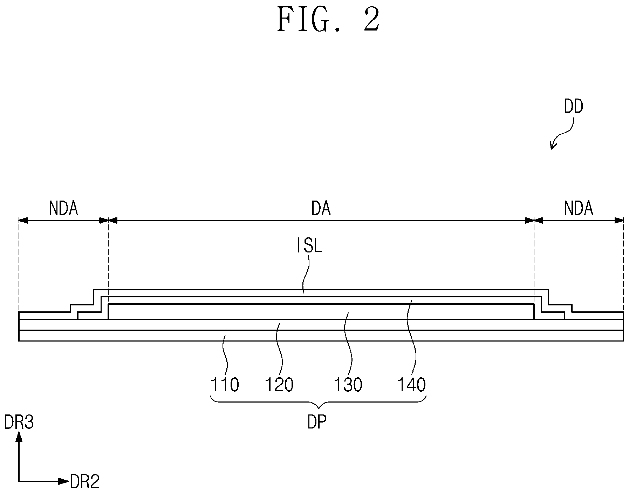

The first area NBA1, the second area NBA2, and the third area BA may be equally applied to a display panel DP (refer to FIG. 2) and an input sensor ISL (refer to FIG. 2) of the display device DD. The display area DA and the non-display area NDA may also be equally applied to the display panel DP (refer to FIG. 2). The input sensor ISL (refer to FIG. 2) may include a sensing area corresponding to the display area DA and a non-sensing area corresponding to the non-display area NDA.

FIG. 2 is a cross-sectional view of the display device DD according to some embodiments of the present invention.

The display module may include the display panel DP and the input sensor ISL. FIG. 2 shows the display panel DP and the input sensor ISL among components of the display device DD. FIG 2 shows a cross-section defined by the second direction DR2 and the third direction DR3 in the first area NBA1.

The display panel DP may be one of a liquid crystal display panel, an electrophoretic display panel, a microelectromechanical system (MEMS) display panel, an electrowetting display panel, an organic light emitting display panel, an inorganic light emitting display panel, and a quantum dot light emitting display panel, however, the present invention should not be limited thereto or thereby. Hereinafter, the organic light emitting display panel will be described as the display panel DP.

The display panel DP may include a base layer 110, a circuit element layer 120 located on the base layer 110, a display element layer 130 located on the circuit element layer 120, and a thin film encapsulation layer 140 located on the display element layer 130. The input sensor ISL may be located directly on the thin film encapsulation layer 140. In the present disclosure, the expression "A component A is located directly on a component B." means that no intervening adhesive layers are present between the component A and the component B.

The base layer 110 may include at least a plastic film. The base layer 110 may be a flexible substrate and may include a plastic substrate, a glass substrate, a metal substrate, or an organic/inorganic composite material substrate. The base layer 110 may include two organic layers and an inorganic layer located between the two organic layers. The display area DA, the non-display area NDA, the first area NBA1, the second area NBA2, and the third area BA described with reference to FIGS. 1A and 1B may be equally applied to the base layer 110.

The circuit element layer 120 may include at least one insulating layer and a circuit element. The insulating layer may include at least one inorganic layer and at least one organic layer. The circuit element may include signal lines and a pixel driving circuit. This will be described in more detail later.

The display element layer 130 may include a display element. The display element layer 130 may further include an organic layer such as a pixel definition layer.

The thin film encapsulation layer 140 may include a plurality of thin layers. Some thin layers may be provided to relatively improve an optical efficiency, and some thin layers may be provided to protect organic light emitting diodes.

The input sensor ISL may obtain coordinate information of an external input. The input sensor ISL may have a multi-layer structure. The input sensor ISL may include a single or multiple conductive layers. The input sensor ISL may include a single or multiple insulating layers.

The input sensor ISL may include one of a capacitive sensor, an optical sensor, an ultrasonic sensor, and an electromagnetic induction sensor. The input sensor ISL may be formed on the display panel DP through successive processes or may be attached to an upper portion of the display panel DP by an adhesive layer after being separately manufactured, however, embodiments according to the present invention are not limited thereto or thereby.

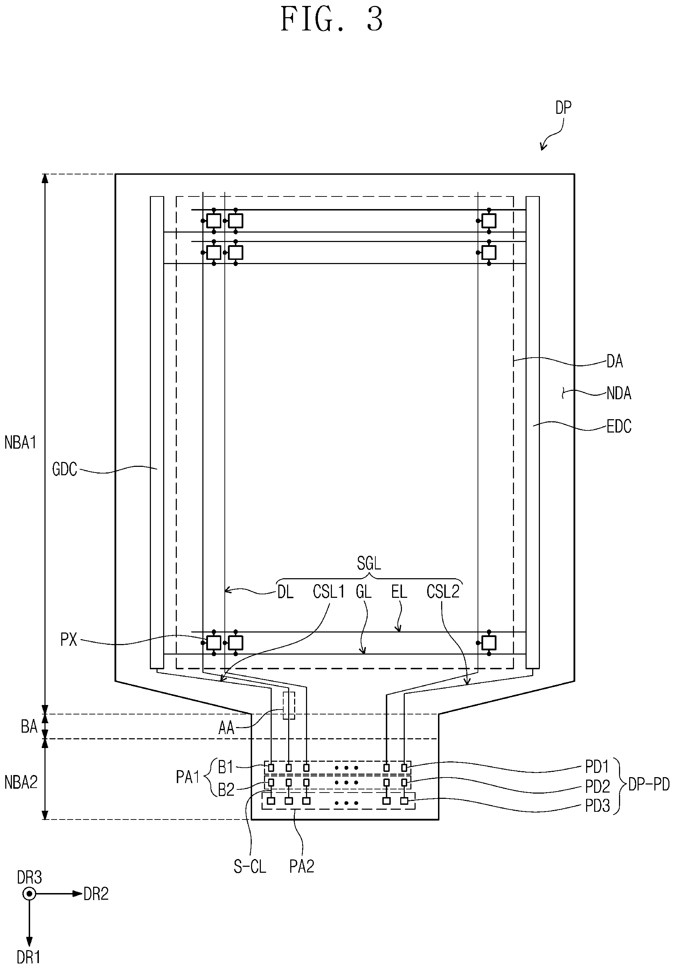

FIG. 3 is a plan view of the display panel DP according to some embodiments of the present invention.

As shown in FIG. 3, the display panel DP may include the display area DA and the non-display area NDA when viewed in the plane (or in a plan view). The display panel DP may include the first area NBA1, the second area NBA2, and the third area BA.

The display panel DP may include driving circuits GDC and EDC, a plurality of signal lines SGL, and a plurality of pixels PX. The pixels PX may be arranged in the display area DA. Each of the pixels PX may include a light emitting element and a pixel driving circuit connected to the light emitting element. The driving circuits GDC and EDC, the signal lines SGL, and the pixel driving circuit may be included in the circuit element layer 120 shown in FIG. 2.

The driving circuits GDC and EDC may include a scan driving circuit GDC and a light emission driving circuit EDC, which are arranged in the non-display area NDA. The scan driving circuit GDC may generate a plurality of scan signals and may sequentially output the scan signals to a plurality of scan lines GL described later. The light emission driving circuit EDC may generate a plurality of pulse signals and may sequentially output the pulse signals to a plurality of light emission signal lines EL described later. The light emission driving circuit EDC may be a second scan driving circuit generating another type of scan signals that are activated in a period different from a period during which the scan signals generated by the scan driving circuit GDC are activated.

Each of the scan driving circuit GDC and the light emission driving circuit EDC may include a plurality of thin film transistors formed through the same process, e.g., a low temperature polycrystalline silicon (LTPS) process or a low temperature polycrystalline oxide (LTPO) process, as the pixel driving circuit of the pixels PX.

The signal lines SGL may include the scan lines GL, the light emission signal lines EL, data lines DL, and signal transmission lines CSL1 and CSL2. Each of the data lines DL may be connected to corresponding pixels among the pixels PX. Each of the data lines DL may provide a data signal from the driving chip DC (refer to FIG. 1A) to the corresponding pixels among the pixels PX. The data lines DL may overlap the first area NBA1, the second area NBA2, and the third area BA.

The signal transmission lines CSL1 and CSL2 may include a first signal transmission line CSL1 that provides signals to the scan driving circuit GDC and a second signal transmission line CSL2 that provides signals to the light emission driving circuit EDC. The first signal transmission line CSL1 and the second signal transmission line CSL2 may overlap the first area NBA1, the second area NBA2, and the third area BA.

Each of the first signal transmission line CSL1 and the second signal transmission line CSL2 is shown as one signal line, however, each of the first signal transmission line CSL1 and the second signal transmission line CSL2 may be provided in plural. The first signal transmission line CSL1 and the second signal transmission line CSL2 may include a first signal line receiving a first bias voltage and a second signal line receiving a second bias voltage lower than the first bias voltage.

The first signal transmission line CSL1 and the second signal transmission line CSL2 may further include a third signal line transmitting a clock signal. The first signal transmission line CSL1 and the second signal transmission line CSL2 may include a plurality of third signal lines transmitting different clock signals.

Each of the scan driving circuit GDC and the light emission driving circuit EDC may receive the clock signal, the first bias voltage, and the second bias voltage and may generate the pulse signal. The scan driving circuit GDC and the light emission driving circuit EDC may receive clock signals different from each other. The first bias voltage applied to the scan driving circuit GDC may have a level different from a level of the first bias voltage applied to the light emission driving circuit EDC, and the second bias voltage applied to the scan driving circuit GDC may have a level different from a level of the second bias voltage applied to the light emission driving circuit EDC.

The display panel DP may include a plurality of signal pads DP-PD arranged in the second area NBA2. The signal pads DP-PD may include first pads PD1, second pads PD2, and third pads PD3.

An area in which the first pads PD1 and the second pads PD2 are arranged may be referred to as a first pad area PA1, and an area in which the third pads PD3 are arranged may be referred to as a second pad area PA2. The first pad area PA1 may be bonded to the driving chip DC (refer to FIG. 1B), and the second pad area PA2 may be bonded to the circuit board. The first pad area PA1 may include a first area B1 in which the first pads PD1 are arranged and a second area B2 in which the second pads PD2 are arranged.

The first pad area PA1 and the second pad area PA2 may be spaced apart from each other in the first direction DR1. The first pads PD1 may be connected to a corresponding signal line among the signal lines DL, CSL1, and CSL2. According to some embodiments, the first pads PD1 may be electrically connected to the second pads PD2. The second pads PD2 may be connected to the third pads PD3 via connection signal lines S-CL. FIG. 3 shows one pad row in the first area B1 as a representative example, however, more pad rows may be arranged in the first area B1. The third pads PD3 may be bonded to pads of the circuit board.

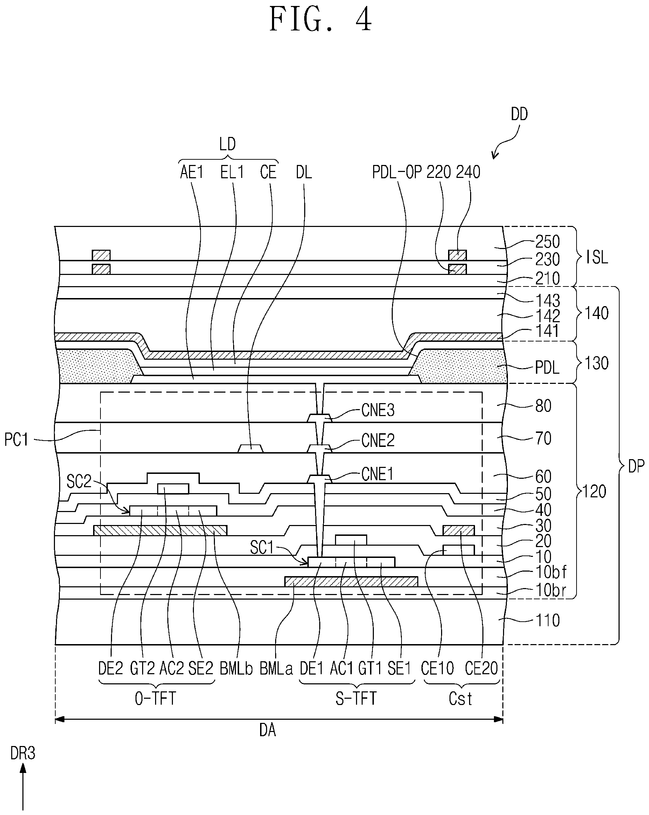

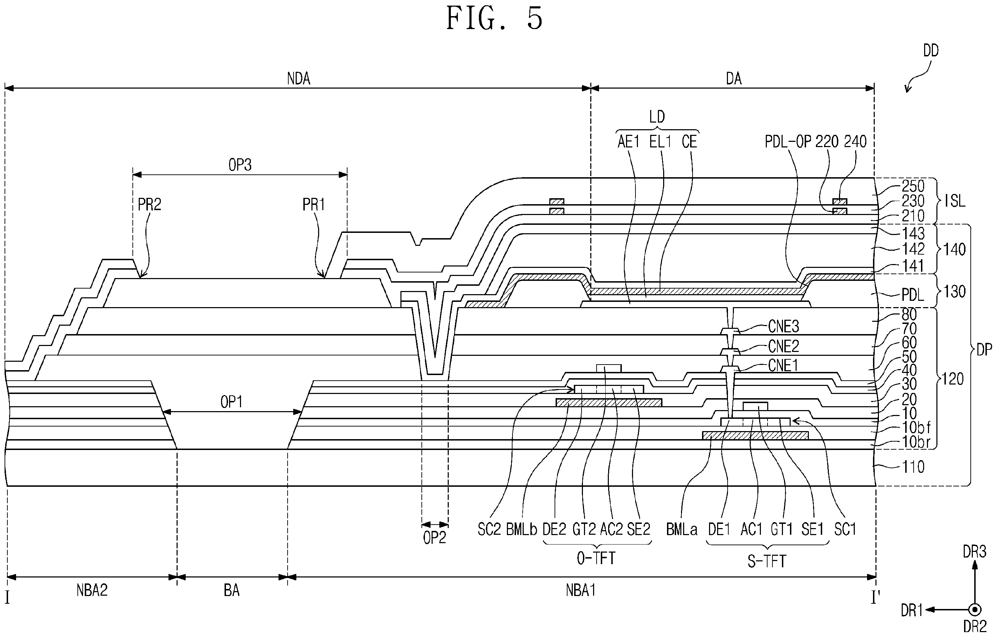

FIGS. 4 and 5 are cross-sectional views of the display device DD according to some embodiments of the present invention. FIG. 4 shows a cross-section corresponding to the pixel PX of FIG. 3, and FIG. 5 shows a cross-section taken along a line I-I' of FIG. 1A, which is centered on the insulating layers. In FIGS. 4 and 5, the insulating layers are illustrated to have different thicknesses from their actual thicknesses in order to explicitly show the insulating layers.

FIG. 4 shows a portion of the light emitting element LD and a portion of a pixel circuit PC1. A silicon transistor S-TFT and an oxide transistor O-TFT are shown as a representative example of the pixel circuit PC1. In the present embodiments, the pixel circuit PC1 including both the silicon transistor S-TFT and the oxide transistor O-TFT will be described as a representative example, however, the pixel circuit PC1 may include only plural silicon transistors S-TFT or may include only plural oxide transistors O-TFT.

Referring to FIG. 4, a barrier layer 10br may be located on the base layer 110. The barrier layer 10br may prevent or reduce instances of a foreign substance or contaminants entering thereinto from the outside. The barrier layer 10br may include at least one inorganic layer. The barrier layer 10br may include a silicon oxide layer and a silicon nitride layer. Each of the silicon oxide layer and the silicon nitride layer may be provided in plural, and the silicon oxide layers and the silicon nitride layers may be alternately stacked with each other.

A first shielding electrode BMLa may be located on the barrier layer 10br. The first shielding electrode BMLa may include a metal material. The first shielding electrode BMLa may include molybdenum (Mo), an alloy including molybdenum (Mo), titanium (Ti), or an alloy including titanium (Ti), which has a good heat resistance. The first shielding electrode BMLa may receive a bias voltage. The first shielding electrode BMLa may receive a power supply voltage. The first shielding electrode BMLa may prevent or reduce instances of an electric potential caused by a polarization phenomenon exerting influence on the silicon transistor S-TFT. The first shielding electrode BMLa may prevent or reduce instances of an external light reaching the silicon transistor S-TFT. According to some embodiments, the first shielding electrode BMLa may be a floating electrode isolated from other electrodes or lines.

A buffer layer 10bf may be located on the barrier layer 10br. The buffer layer 10bf may prevent or reduce instances of metal atoms or impurities being diffused to a first semiconductor pattern SC1 located thereon from the base layer 110. The buffer layer 10bf may include at least one inorganic layer. The buffer layer 10bf may include a silicon oxide layer and a silicon nitride layer.

The first semiconductor pattern SC1 may be located on the buffer layer 10bf. The first semiconductor pattern SC1 may include a silicon semiconductor. As an example, the silicon semiconductor may include amorphous silicon or polycrystalline silicon. For example, the first semiconductor pattern SC1 may include low temperature polycrystalline silicon.

FIG. 4 shows only a portion of the first semiconductor pattern SC1, and the first semiconductor pattern SC1 may be further located in another area. The first semiconductor pattern SC1 may be arranged in a specific rule over the pixels. The first semiconductor pattern SC1 may have different electrical properties depending on whether it is doped or not. The first semiconductor pattern SC1 may include a first region having a relatively high conductivity and a second region having a relatively low conductivity. The first region may be doped with an N-type dopant or a P-type dopant. A P-type transistor may include a doped region doped with the P-type dopant, and an N-type transistor may include a doped region doped with the N-type dopant. The second region may be a non-doped region or a region doped at a concentration lower than that of the first region.

The first region may have a conductivity greater than that of the second region and may serve (or substantially serve) as an electrode or a signal line. The second region may correspond (or substantially correspond) to a channel area (or an active area) of the transistor. In other words, a portion of the first semiconductor pattern SC1 may be a channel of the transistor, another portion of the first semiconductor pattern SC1 may be a source or a drain of the transistor, and the other portion of the first semiconductor pattern SC1 may be a connection electrode or a connection signal line.

A source area SE1, a channel area AC1 (or an active area), and a drain area DE1 of the silicon transistor S-TFT may be formed from the first semiconductor pattern SC1. The source area SE1 and the drain area DE1 may extend in opposite directions to each other from the channel area AC1 in a cross-section.

A first insulating layer 10 may be located on the buffer layer 10bf. The first insulating layer 10 may cover the first semiconductor pattern SC1. The first insulating layer 10 may be an inorganic layer. The first insulating layer 10 may have a single-layer structure of a silicon oxide layer. The first insulating layer 10 may have a multi-layer structure as well as the single-layer structure. An inorganic layer of the circuit element layer 120 described in more detail later may have a single-layer or multi-layer structure and may include at least one of the above-mentioned materials, however, embodiments according to some embodiments of the present invention are not limited thereto or thereby.

A gate GT1 of the silicon transistor S-TFT may be located on the first insulating layer 10. The gate GT1 may be a portion of a metal pattern. The gate GT1 may overlap the channel area AC1. The gate GT1 may be used as a mask in a process of doping the first semiconductor pattern SC1.

A first electrode CE10 of a storage capacitor Cst may be located on the first insulating layer 10. According to some embodiments, the first electrode CE10 may be formed integrally with the gate GT1.

A second insulating layer 20 may be located on the first insulating layer 10 and may cover the gate GT1. According to some embodiments, an upper electrode may be located on the second insulating layer 20 and may overlap the gate GT1. A second electrode CE20 may be located on the second insulating layer 20 and may overlap the first electrode CE10.

A second shielding electrode BMLb may be located on the second insulating layer 20. The second shielding electrode BMLb may be located under the oxide transistor O-TFT. According to some embodiments, the second shielding electrode BMLb may be omitted. According to some embodiments, the first shielding electrode BMLa may extend to a lower side of the oxide transistor O-TFT to replace the second shielding electrode BMLb.

A third insulating layer 30 may be located on the second insulating layer 20. A second semiconductor pattern SC2 may be located on the third insulating layer 30. The second semiconductor pattern SC2 may include a channel area AC2 of the oxide transistor O-TFT. The second semiconductor pattern SC2 may include an oxide semiconductor. The second semiconductor pattern SC2 may include a transparent conductive oxide (TCO), such as indium tin oxide (ITO), indium zinc oxide (IZO), indium gallium zinc oxide (IGZO), zinc oxide (ZnOx), or indium oxide (In₂O₃).

The oxide semiconductor may include a plurality of areas distinguished from each other depending on whether a transparent conductive oxide is reduced. The area (hereinafter, referred to as a reduced area) in which the transparent conductive oxide is reduced has a conductivity greater than that of the area (hereinafter, referred to as a non-reduced area) in which the transparent conductive oxide is not reduced. The reduced area may act as the source/drain of the transistor or the signal line. The non-reduced area may correspond or (substantially correspond) to the semiconductor area (or the channel) of the transistor. In other words, a portion of the second semiconductor pattern SC2 may be the semiconductor area of the transistor, another portion of the second semiconductor pattern SC2 may be the source area/drain area of the transistor, and the other portion of the second semiconductor pattern SC2 may be a signal transmission area.

A fourth insulating layer 40 may be located on the third insulating layer 30. As shown in FIG. 4, the fourth insulating layer 40 may cover the oxide transistor O-TFT. According to some embodiments, the fourth insulating layer 40 may overlap a gate GT2 of the oxide transistor O-TFT and may be an insulating pattern through which a source area SE2 and a drain area DE2 of the oxide transistor O-TFT are exposed.

The gate GT2 of the oxide transistor O-TFT may be located on the fourth insulating layer 40. The gate GT2 of the oxide transistor O-TFT may be a portion of a metal pattern. The gate GT2 of the oxide transistor O-TFT may overlap the channel area AC2.

A fifth insulating layer 50 may be located on the fourth insulating layer 40, and the fifth insulating layer 50 may cover the gate GT2. Each of the first to fifth insulating layers 10 to 50 may be an inorganic layer.

A first connection electrode CNE1 may be located on the fifth insulating layer 50. The first connection electrode CNE1 may be connected to the drain area DE1 of the silicon transistor S-TFT via a contact hole defined through the first, second, third, fourth, and fifth insulating layers 10, 20, 30, 40, and 50.

A sixth insulating layer 60 may be located on the fifth insulating layer 50. A second connection electrode CNE2 may be located on the sixth insulating layer 60. The second connection electrode CNE2 may be connected to the first connection electrode CNE1 via a contact hole defined through the sixth insulating layer 60. The data line DL may be located on the sixth insulating layer 60. A seventh insulating layer 70 may be located on the sixth insulating layer 60 and may cover the second connection electrode CNE2 and the data line DL. A third connection electrode CNE3 may be located on the seventh insulating layer 70. The third connection electrode CNE3 may be connected to the second connection electrode CNE2 via a contact hole defined through the seventh insulating layer 70. An eighth insulating layer 80 may be located on the seventh insulating layer 70 and may cover the third connection electrode CNE3. Each of the sixth insulating layer 60, the seventh insulating layer 70, and the eighth insulating layer 80 may be an organic layer.

In the present embodiments, the circuit element layer 120 including seven conductive layers including the first shielding electrode BMLa, the gate GT1 of the silicon transistor S-TFT, the second shielding electrode BMLb, the gate GT2 of the oxide transistor O-TFT, the first connection electrode CNE1, the second connection electrode CNE2, and the third connection electrode CNE3 is shown as a representative example. Each of the first shielding electrode BMLa, the gate GT1 of the silicon transistor S-TFT, the second shielding electrode BMLb, the gate GT2 of the oxide transistor O-TFT, the first connection electrode CNE1, the second connection electrode CNE2, and the third connection electrode CNE3 may be formed from a corresponding conductive layer by patterning first to seventh conductive layers. According to some embodiments, the number of the conductive layers may be changed. The circuit element layer 120 may include four to seven conductive layers.

The light emitting element LD may include an anode AE1 (or a first electrode), a light emitting layer EL1, and a cathode CE (or a second electrode). The cathode CE may be commonly provided in the light emitting elements of the pixels PX (refer to FIG. 3).

The anode AE1 of the light emitting element LD may be located on the eighth insulating layer 80. The anode AE1 may be a transmissive electrode, a semi-transmissive electrode, or a reflective electrode. The pixel definition layer PDL may be located on the eighth insulating layer 80. The pixel definition layer PDL may have a light absorbing property, and for example, the pixel definition layer PDL may have a black color. The pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to a light blocking pattern having a light blocking property.

The pixel definition layer PDL may cover a portion of the anode AE1. As an example, the pixel definition layer PDL may be provided with an opening PDL-OP defined therethrough to expose a portion of the anode AE1.

According to some embodiments, a hole control layer may be located between the anode AE1 and the light emitting layer EL1. The hole control layer may include a hole transport layer and/or a hole injection layer. An electron control layer may be located between the light emitting layer EL1 and the cathode CE. The electron control layer may include an electron transport layer and/or an electron injection layer. The hole control layer and the electron control layer may be commonly formed over the plural pixels PX (refer to FIG. 3) using an open mask.

The thin film encapsulation layer 140 may be located on the display element layer 130. The thin film encapsulation layer 140 may include an inorganic layer 141, an organic layer 142, and an inorganic layer 143, which are sequentially stacked, however, layers included in the thin film encapsulation layer 140 should not be limited thereto or thereby.

The inorganic layers 141 and 143 may protect the display element layer 130 from moisture and oxygen, and the organic layer 142 may protect the display element layer 130 from a foreign substance such as dust particles. The inorganic layers 141 and 143 may include a silicon nitride layer, a silicon oxynitride layer, a silicon oxide layer, a titanium oxide layer, or an aluminum oxide layer. The organic layer 142 may include an acrylic-based organic layer, however, it should not be limited thereto or thereby.

The input sensor ISL may be located on the display panel DP. The input sensor ISL may include at least one conductive layer and at least one insulating layer. According to some embodiments, the input sensor ISL may include a first insulating layer 210, a first conductive layer 220, a second insulating layer 230, a second conductive layer 240, and a third insulating layer 250.

The first insulating layer 210 may be located directly on the display panel DP. The first insulating layer 210 may be an inorganic layer including at least one of silicon nitride, silicon oxynitride, or silicon oxide. Each of the first conductive layer 220 and the second conductive layer 240 may have a single-layer structure or a multi-layer structure of layers stacked in the third direction DR3. The first conductive layer 220 and the second conductive layer 240 may include conductive lines to define electrodes having a mesh shape. The conductive line of the first conductive layer 220 may be connected to the conductive line of the second conductive layer 240 via a contact hole defined through the second insulating layer 230 or may not be connected. The connection relationship between the conductive line of the first conductive layer 220 and the conductive line of the second conductive layer 240 may be determined depending on a type of sensor applied to the input sensor ISL.

The first and second conductive layers 220 and 240 having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide (IZO), zinc oxide (ZnOx), indium zinc tin oxide (ITZO), or the like. In addition, the transparent conductive layer may include conductive polymer such as PEDOT, metal nanowire, graphene, or the like.

The first and second conductive layers 220 and 240 having the multi-layer structure may include metal layers. The metal layers may have a three-layer structure of titanium/aluminum/titanium. The first and second conductive layers 220 and 240 having the multi-layer structure may include at least one metal layer and at least one transparent conductive layer.

The second insulating layer 230 may cover the first conductive layer 220. The second insulating layer 230 may include an inorganic layer including at least one of silicon nitride, silicon oxynitride, or silicon oxide.

The third insulating layer 250 may cover the second conductive layer 240. The third insulating layer 250 may include an organic layer.

Referring to FIG. 5, the inorganic layers 10br, 10bf, and 10 to 50 may be located on the base layer 110. The inorganic layers 10br, 10bf, and 10 to 50 may include the barrier layer 10br, the buffer layer 10bf, and the first to fifth insulating layers 10 to 50. The inorganic layers 10br, 10bf, and 10 to 50 may overlap the first area NBA1 and the second area NBA2. The inorganic layers 10br, 10bf, and 10 to 50 may be provided with an opening OP1 (hereinafter, referred to as a first opening) defined therethrough and corresponding to the third area BA. The first opening OP1 may be defined to prevent or reduce damage to the inorganic layers 10br, 10bf, and 10 to 50 due to a stress occurring when the third area BA is bent as shown in FIG. 1B. The first opening OP1 may extend in the second direction DR2.

The organic layers 60, 70, 80, and PDL may be located on the inorganic layers 10br, 10bf, and 10 to 50. The organic layers 60, 70, 80, and PDL may include the sixth, seventh, and eighth insulating layers 60, 70, and 80 and the pixel definition layer PDL. The first opening OP1 may be filled with the sixth insulating layer 60.

The sixth insulating layer 60 to the eighth insulating layer 80 may be provided with an opening OP2 (hereinafter, referred to as a second opening) defined therethrough and corresponding to the non-display area NDA of the first area NBA1. The second opening OP2 may extend in the second direction DR2, and the fifth insulating layer 50 may be exposed through the second opening OP2. The inorganic layers 141 and 143 of the thin film encapsulation layer 140 may be located in the second opening OP2 and may be in contact with the fifth insulating layer 50.

The first insulating layer 210 and the second insulating layer 230 of the input sensor ISL, which are the inorganic layer, may overlap the first area NBA1 and the second area NBA2. The first insulating layer 210 and the second insulating layer 230 of the input sensor ISL may be provided with an opening OP3 (hereinafter, referred to as a third opening) defined therethrough and corresponding to the third area BA. The third opening OP3 may be defined to prevent or reduce damage to the first insulating layer 210 and the second insulating layer 230 of the input sensor ISL due to a stress occurring when the third area BA is bent as shown in FIG. 1B. The third opening OP3 may extend in the second direction DR2. According to some embodiments, the third insulating layer 250 of the input sensor ISL, which is the organic layer, may overlap the first area NBA1 and may not overlap the second area NBA2 and the third area BA, however, embodiments according to the present invention are not limited thereto or thereby.

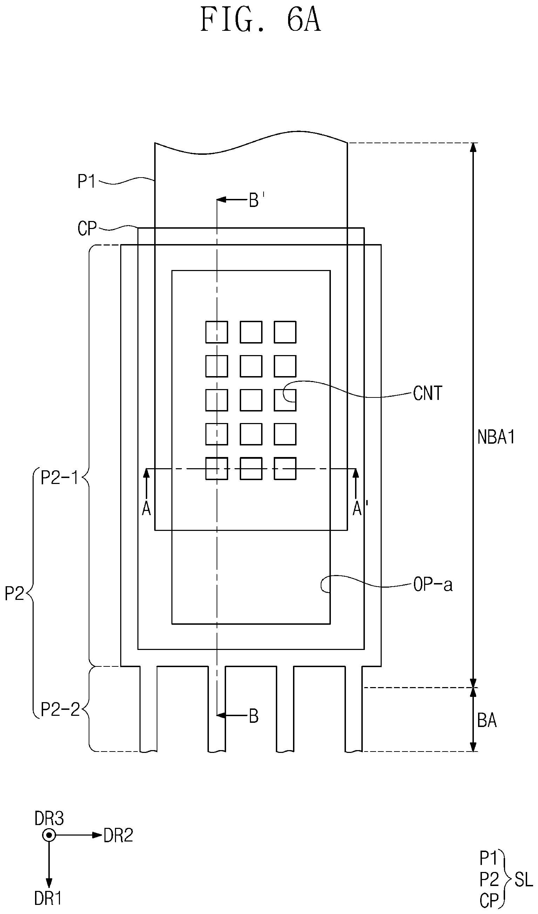

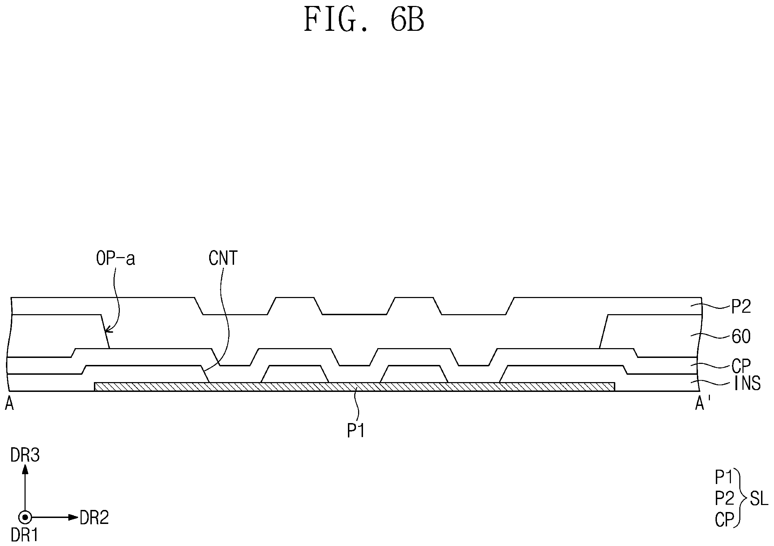

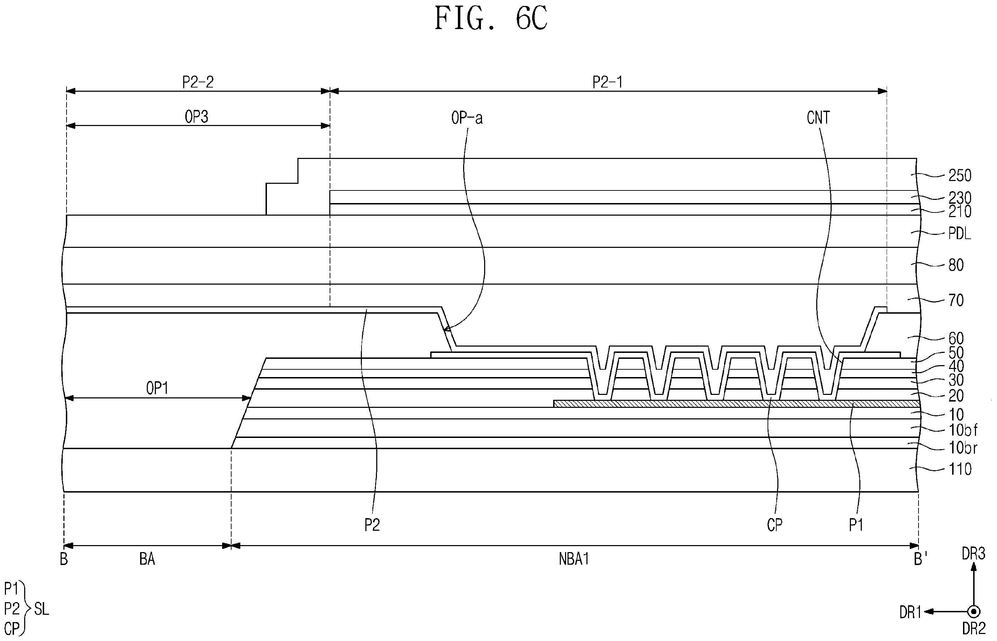

FIG. 6A is a plan view of a signal line SL according to some embodiments of the present invention. FIGS. 6B and 6C are cross-sectional views of the signal line SL according to some embodiments of the present invention.

The signal line SL shown in FIGS. 6A to 6C may correspond to the data lines DL or the signal transmission lines CSL1 and CSL2 described with reference to FIG. 3. For instance, FIG. 6A is an enlarged plan view of the data line DL located in the area AA shown in FIG. 3. In addition, the signal line SL should not be limited by the type of signal or voltage to transmit. It is sufficient for the signal line SL to satisfy structural characteristics described below.

Referring to FIG. 6A, the signal line SL may include a first line portion P1, a second line portion P2, and a connection portion CP.

The first line portion P1 may be located in the first area NBA1. The first line portion P1 may be electrically connected to the second line portion P2 through the connection portion CP.

The second line portion P2 may be located in the first area NBA1, the second area NBA2, and the third area BA. The second line portion P2 may extend from the first area NBA1 to the second area NBA2 through the third area BA. For the sake of explanation, FIG. 6A shows only a portion of the second line portion P2, however, as shown in FIG. 3, the portion of the signal line SL extending from the first area NBA1 to the second area NBA2 may correspond to the second line portion P2.

The second line portion P2 may include a contact portion P2-1 and a plurality of line portions P2-2. The contact portion P2-1 may be located in the first area NBA1. The contact portion P2-1 may overlap the connection portion CP. The line portions P2-2 may be located at least in the third area BA. Each of the line portions P2-2 may extend from the contact portion P2-1 to the first direction DR1. The line portions P2-2 may extend to and may be located in the second area NBA2. The line portions P2-2 may be arranged in the second direction DR2. The line portions P2-2 may lower a resistance and may relatively improve a flexibility of the second line portion P2.

The second line portion P2 may further include a contact portion located in the second area NBA2. In this case, the contact portion P2-1 located in the first area NBA1 may be referred to as a first contact portion, and the contact portion located in the second area NBA2 may be referred to as a second contact portion. The second contact portion may extend from the line portions P2-2 to the first direction DR1 and may be located in the second area NBA2. Descriptions on the contact portion P2-1 may be applied to the second contact portion except the second contact portion is located in the second area NBA2. The second contact portion may overlap the first pad PD1 (refer to FIG. 3). The second contact portion may be connected to the first pad PD1 (refer to FIG. 3).

The connection portion CP may be located in the first area NBA1. The connection portion CP may overlap a portion of the first line portion P1. The connection portion CP may overlap a portion of the second line portion P2. The first line portion P1 may be electrically connected to the second line portion P2 by the connection portion CP.

The signal line SL may further include a third line portion located in the second area NBA2 and extending in the first direction DR1 and a connection portion electrically connecting the second line portion P2 and the third line portion. In this case, the connection portion CP electrically connecting the first line portion P1 and the second line portion P2 may be referred to as a first connection portion, and the connection portion electrically connecting the second line portion P2 and the third line portion may be referred to as a second connection portion. The second connection portion may overlap a portion of the second line portion P2 located in the second area NBA2. The second connection portion may overlap a portion of the third line portion.

The signal line SL may further include another portion located in the first area NBA1 and electrically connected to the first line portion P1. As an example, the data line DL shown in FIG. 3 may further include a line portion electrically connected to the first line portion P1, located on a different layer from the first line portion P1, and located in the display area DA.

FIG. 6B is a cross-sectional view taken along a line A-A'. The first line portion P1, the second line portion P2, and the connection portion CP may be located on different layers from each other.

An insulating layer INS may be located between the first line portion P1 and the connection portion CP. The insulating layer INS may correspond to the second, third, fourth, and fifth insulating layers 20, 30, 40, and 50 of FIGS. 5 and 6C. A contact hole CNT may be defined through the insulating layer INS. In FIG. 6A, the insulating layer INS is not shown, but a position of the contact hole CNT is shown.

When viewed in the plane (or in a plan view), the contact hole CNT may overlap the first line portion P1, the connection portion CP, and the second line portion P2. When viewed in the plane (or in a plan view), the contact hole CNT may overlap an organic layer opening OP-a.

The first line portion P1 may be exposed through the contact hole CNT defined through the insulating layer INS. The exposed first line portion P1 may be covered by the connection portion CP. Accordingly, the first line portion P1 and the connection portion CP may be in contact with and electrically connected to each other via the contact hole CNT.

The organic layer 60 may be located between the connection portion CP and the second line portion P2. The organic layer 60 may be provided with an organic layer opening OP-a defined therethrough. In FIG. 6A, the organic layer 60 is not shown, but a position of the organic layer opening OP-a is shown. When viewed in the plane (or in a plan view), the organic layer opening OP-a may be defined inside the connection portion CP. In addition, when viewed in the plane (or in a plan view), the organic layer opening OP-a may be defined to extend to an area where the first line portion P1 is not located.

The connection portion CP may be exposed through the organic layer opening OP-a defined through the organic layer 60. The exposed connection portion CP may be covered by the second line portion P2. The second line portion P2 may be located directly on an upper surface of the connection portion CP exposed through the organic layer opening OP-a. Accordingly, the connection portion CP and the second line portion P2 may be in contact with and electrically connected to each other via the organic layer opening OP-a.

FIG. 6C shows a cross-section of the display device DD (refer to FIG. 1A) taken along a line B-B' of FIG. 6A.

Referring to FIG. 6C, the first line portion P1 may be located on the first insulating layer 10. According to some embodiments, the first line portion P1 located on the same layer as the gate GT1 of the silicon transistor S-TFT of FIG. 4 is shown as a representative example, however, embodiments according to the present invention are not limited thereto or thereby. The first line portion P1 may be located on the same layer as the second shielding electrode BMLb of FIG. 4 or the gate GT2 of the oxide transistor O-TFT of FIG. 4. In the present disclosure, the expression "A component A is located on the same layer as a component B." means that they are formed by the same process and that they have the same material and the same stacked structure.

As an example, the first line portion P1 may include molybdenum. The first line portion P1 may include copper/titanium or molybdenum/titanium. The second line portion P2 and the connection portion CP may include aluminum. The second line portion P2 and the connection portion CP may include titanium/aluminum/titanium.

The connection portion CP may be connected to the first line portion P1 via the contact hole CNT defined through the second, third, fourth, and fifth insulating layers 20, 30, 40, and 50. FIGS. 6A to 6C show a plurality of contact holes arranged in five rows by three columns, however, the number of the contact holes CNT should not be limited thereto or thereby. In addition, the contact hole CNT may have a square shape when viewed in the plane (or in a plan view), however, the shape of the contact hole CNT should not be limited thereto or thereby.

In FIG. 6C, a depth of the contact hole CNT is depicted as significantly greater than its diameter. However, this is only due to the scale of the drawing, and the diameter of the contact hole CNT may be equal to or greater than its depth. Even though the diameter of the contact hole CNT is smaller than the depth of the contact hole CNT, the difference may be slight. Because the thickness of the inorganic layers, e.g., the second, third, fourth, and fifth insulating layers 20, 30, 40, and 50, is thin, the difference between the diameter of the contact hole CNT and the depth of the contact hole CNT may be small even though the plural contact holes CNTs are formed in a small area. As an example, each of the second, third, fourth, and fifth insulating layers 20, 30, 40, and 50 may have a thickness in a range of 1500Å to 2500Å (or about 1500Å to about 2500Å).

The second line portion P2 may be in contact with and may be electrically connected to the connection portion CP via the organic layer opening OP-a defined through the sixth insulating layer 60.

In an area where the contact hole CNT is not defined, the connection portion CP and the second line portion P2 may be in contact with each other in a flat shape.

The seventh insulating layer 70 may be located on the sixth insulating layer 60 and may cover the second line portion P2.

Because the first insulating layer 210 and the second insulating layer 230 of the input sensor ISL, which are the inorganic layer, overlap the first area NBA1 and do not overlap the third area BA, a moisture penetration path may be provided.

The first insulating layer 210 that is the inorganic layer is damaged by an outgas generated from the organic layers 60, 70, 80, and PDL located under the first insulating layer 210 and the second insulating layer 230 and moisture penetrating between the first insulating layer 210 and the pixel definition layer PDL, and thus, a hydrogen radical and an ammonia (NH3) gas are generated from the first insulating layer 210. For instance, the first insulating layer 210, a silicon nitride layer, is oxidized to generate the hydrogen radical and the ammonia (NH3) gas. The hydrogen radical and the ammonia (NH3) gas react with water (H2O) infiltrated therein to generate hydrogen ions and ammonium ions. The hydrogen ions and the ammonium ions are diffused to cause corrosion on the connection portion CP. In particular, microcracks may occur in the connection portion CP due to a step difference caused by the contact hole CNT.

However, according to some embodiments of the present invention, because the second line portion P2 extends to the area in which the contact hole CNT is defined, the second line portion P2 may be arranged to cover the contact hole CNT and the connection portion CP around the contact hole CNT. Accordingly, penetration of moisture or other contaminants may be prevented or reduced, and thus, corrosion of the connection portion CP may be prevented or reduced.

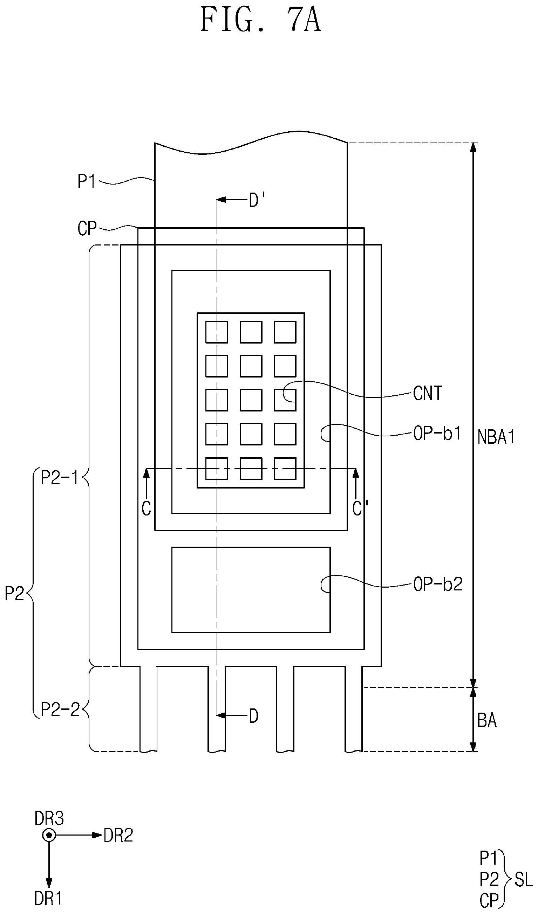

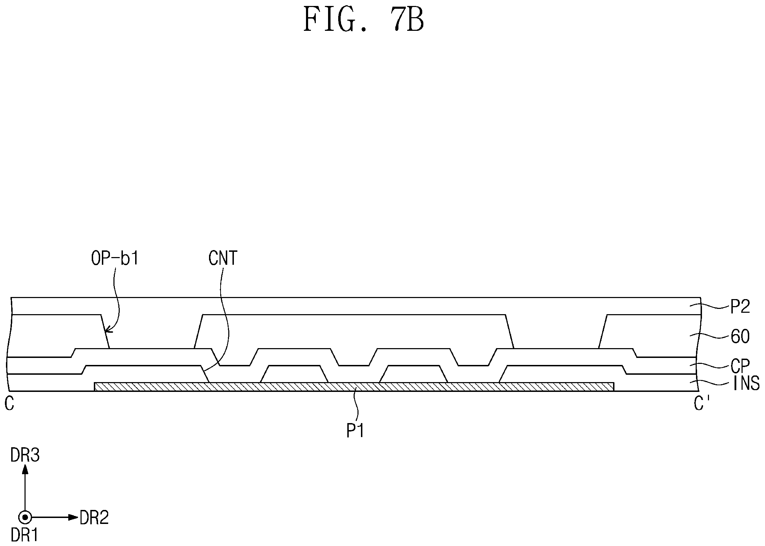

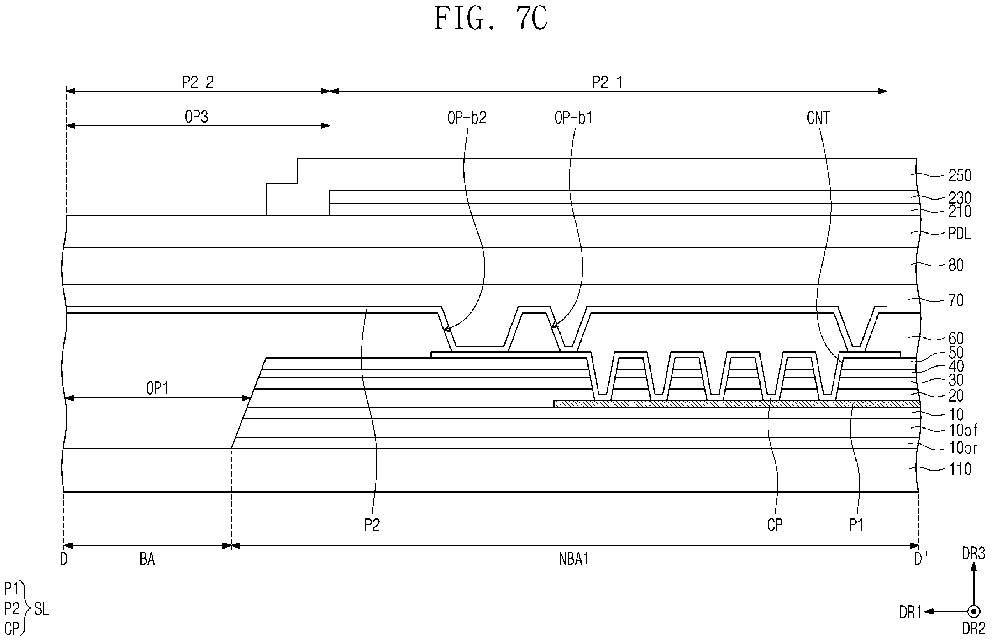

FIG. 7A is a plan view of a signal line SL according to some embodiments of the present invention. FIGS. 7B and 7C are cross-sectional views of the signal line SL according to some embodiments of the present invention.

FIGS. 7A to 7C show the signal line SL according to some embodiments of the present invention. Descriptions on the signal line SL of FIGS. 6A to 6C may be applied to the signal line SL of FIGS. 7A to 7C except an arrangement of a second line portion P2 according to a structure of an organic layer, i.e., a sixth insulating layer 60.

FIG. 7B shows a cross-section taken along a line C-C' of FIG. 7A. FIG. 7C shows a cross-section of a display device (refer to DD of FIG. 1A) taken along a line D-D' of FIG. 7A.

For the convenience of explanation, a thickness and a shape of an upper surface of the second line portion P2 shown in FIG. 7B are shown differently from those of FIG. 7C, but the thickness and the shape of the upper surface of the second line portion P2 should not be limited thereto or thereby.

A first organic layer opening OP-b1 and a second organic layer opening OP-b2 spaced apart from the first organic layer opening OP-b1 may be defined through the organic layer 60. When viewed in the plane (or in a plan view), the first organic layer opening OP-b1 and the second organic layer opening OP-b2 may be located inside a connection portion CP.

When viewed in the plane (or in a plan view), the first organic layer opening OP-b1 may be located inside a first line portion P1. When viewed in the plane (or in a plan view), the first organic layer opening OP-b1 may be defined to surround an area where a contact hole CNT is defined. When viewed in the plane (or in a plan view), the first organic layer opening OP-b1 may not overlap the area where the contact hole CNT is defined. When viewed in the plane (or in a plan view), a portion of the organic layer 60, which is provided with the contact hole CNT defined therethrough, may be spaced apart from a portion of the organic layer 60, which is not provided with the contact hole CNT, by the first organic layer opening OP-b1.

The second line portion P2 may be located directly on the portion of the organic layer 60, which is provided with the contact hole CNT defined therethrough. The second line portion P2 may be located directly on the connection portion CP exposed through the first organic layer opening OP-b1. As the second line portion P2 is located directly on the connection portion CP exposed through the first organic layer opening OP-b1, the connection portion CP may be electrically connected to the second line portion P2.

When viewed in the plane (or in a plan view), the second organic layer opening OP-b2 may be located outside the first line portion P1. However, different from this structure, the second organic layer opening OP-b2 may be located inside the first line portion P1. The second organic layer opening OP-b2 may not overlap the portion where the contact hole CNT is located. The connection portion CP may be exposed through the second organic layer opening OP-b2, and the exposed connection portion CP may be covered by the second line portion P2. The connection portion CP and the second line portion P2, which are located in the second organic layer opening OP-b2, may be in contact with each other in a flat shape.

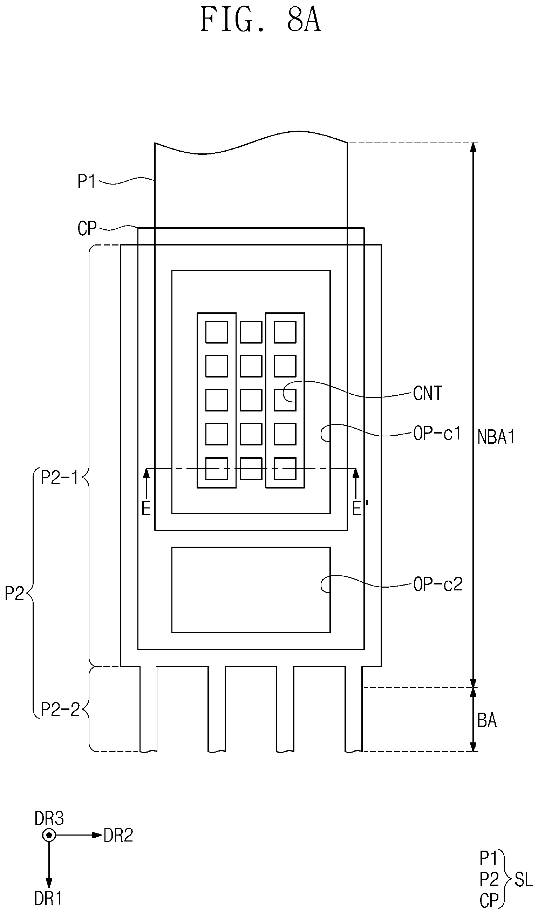

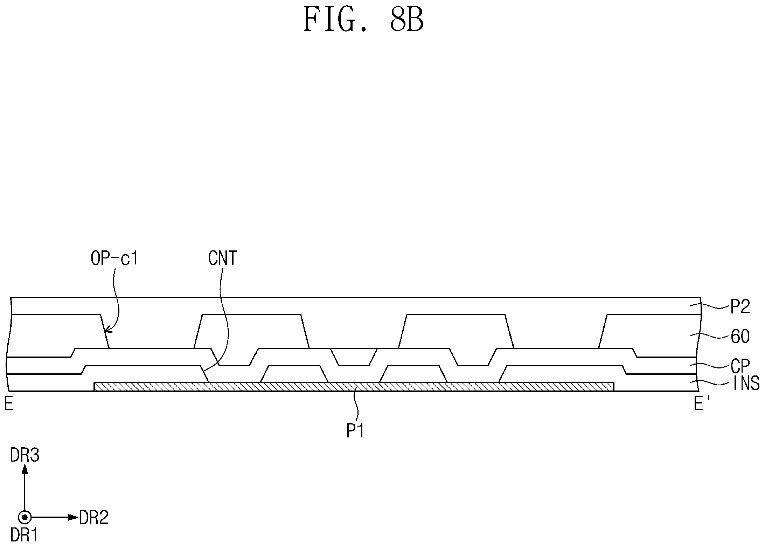

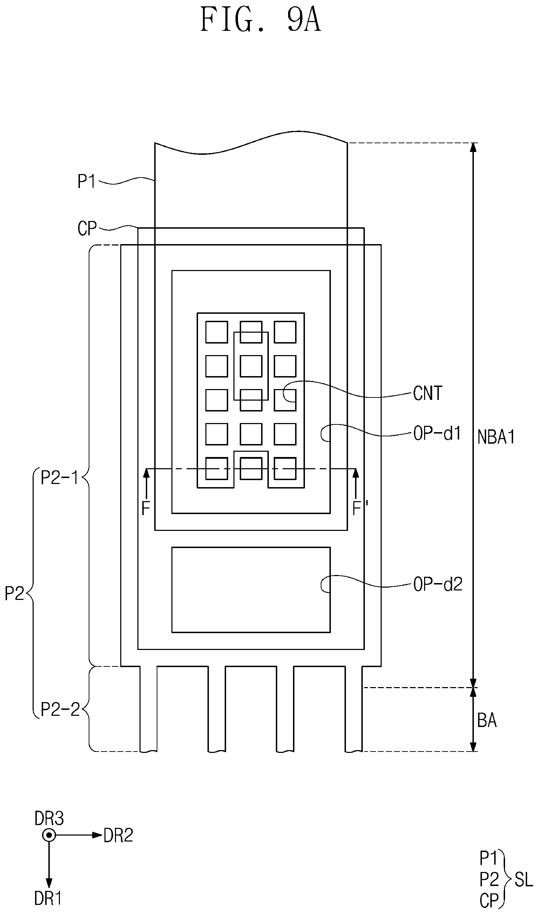

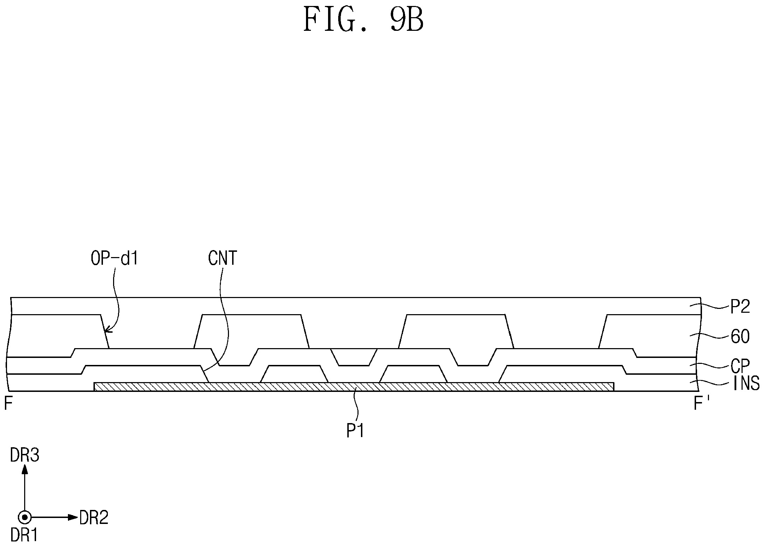

FIG. 8A is a plan view of a signal line SL according to some embodiments of the present invention. FIG. 8B is a cross-sectional view of the signal line SL according to some embodiments of the present invention. FIG. 9A is a plan view of a signal line SL according to some embodiments of the present invention. FIG. 9B is a cross-sectional view of the signal line SL according to some embodiments of the present invention.

FIGS. 8A to 9B are views of the signal lines SL according to embodiments of the present invention. Descriptions on the signal line SL of FIGS. 6A to 6C may be applied to the signal lines SL of FIGS. 8A to 9B except an arrangement of a second line portion P2 according to a structure of an organic layer, i.e., a sixth insulating layer 60.

FIG. 8B shows a cross-section taken along a line E-E' of FIG. 8A. FIG. 9B shows a cross-section taken along a line F-F' of FIG. 9A.

Referring to FIGS. 8A and 8B, a first organic layer opening OP-c1 and a second organic layer opening OP-c2 spaced apart from the first organic layer opening OP-c1 may be defined through the organic layer 60. When viewed in the plane (or in a plan view), the first organic layer opening OP-c1 and the second organic layer opening OP-c2 may be located inside a connection portion CP.

When viewed in the plane (or in a plan view), the first organic layer opening OP-c1 may be located inside a first line portion P1. When viewed in the plane (or in a plan view), the first organic layer opening OP-c1 may surround an area where a contact hole CNT is located and may overlap at least a portion of the contact hole CNT.

The second line portion P2 may be located directly on the connection portion CP exposed through the first organic layer opening OP-c1. As the second line portion P2 is located directly on the connection portion CP exposed through the first organic layer opening OP-c1, the connection portion CP may be electrically connected to the second line portion P2.

When viewed in the plane (or in a plan view), the second organic layer opening OP-c2 may be located outside the first line portion P1. However, different from this structure, the second organic layer opening OP-c2 may be located inside the first line portion P1. The second organic layer opening OP-c2 may not overlap the area where the contact hole CNT is located. The connection portion CP may be exposed through the second organic layer opening OP-c2, and the exposed connection portion CP may be covered by the second line portion P2. The connection portion CP and the second line portion P2, which are located in the second organic layer opening OP-c2, may include portions that are in contact with each other in a flat shape.

The above descriptions on the first and second organic layer openings OP-c1 and OP-c2 of FIGS. 8A and 8B may be applied to a first organic layer opening OP-d1 and a second organic layer opening OP-d2 of FIGS. 9A and 9B except that the first organic layer opening OP-d1 includes two openings.

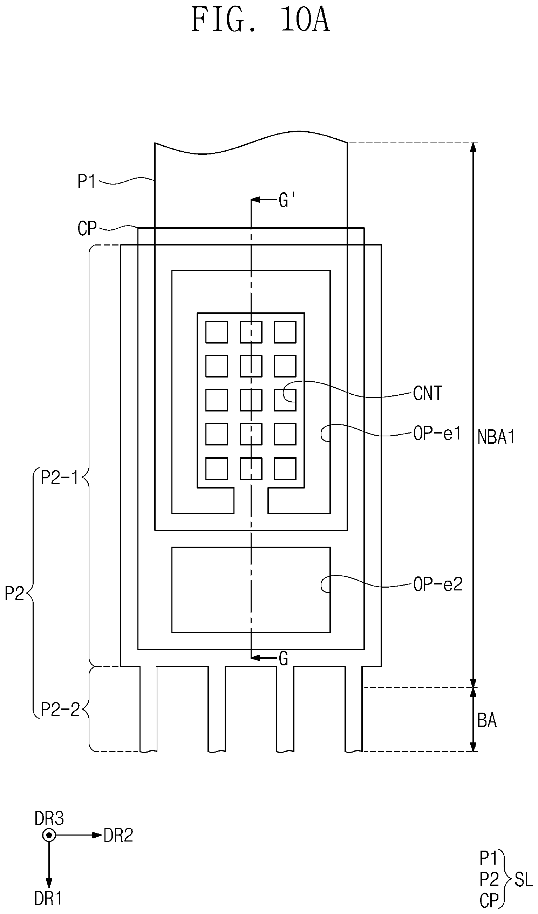

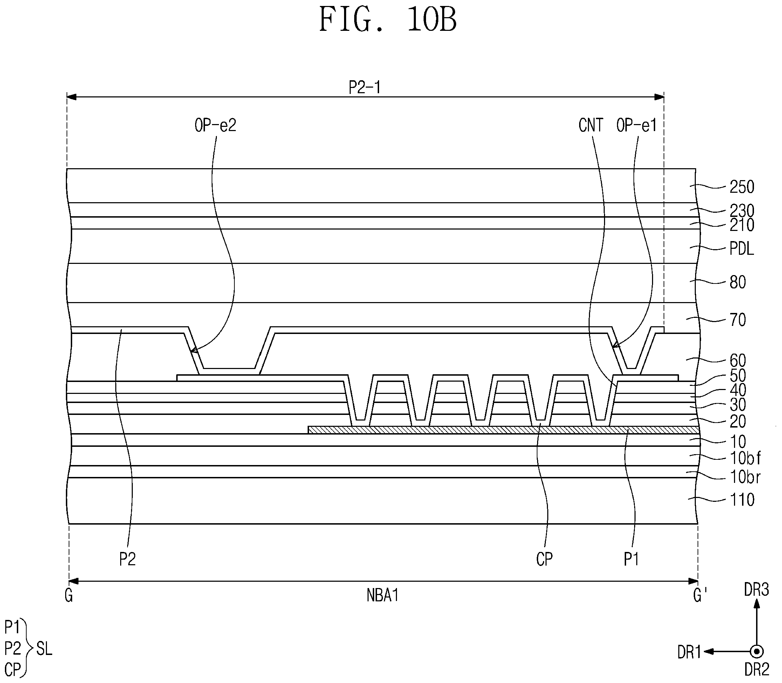

FIG. 10A is a plan view of a signal line SL according to some embodiments of the present invention. FIG. 10B is a cross-sectional view of the signal line SL according to some embodiments of the present invention.

FIGS. 10A and 10B are views of the signal line SL according to some embodiments of the present invention. The above descriptions on the signal line SL of FIGS. 6A to 6C may be applied to the signal line SL of FIGS. 10A and 10B except an arrangement of a second line portion P2 according to a structure of an organic layer, i.e., a sixth insulating layer 60.

FIG. 10B shows a cross-section of a display device (refer to DD of FIG. 1A) taken along a line G-G' of FIG. 10A.

A first organic layer opening OP-e1 and a second organic layer opening OP-e2 spaced apart from the first organic layer opening OP-e1 may be defined through the organic layer 60. When viewed in the plane (or in a plan view), the first organic layer opening OP-e1 and the second organic layer opening OP-e2 may be located inside a connection portion CP.

When viewed in the plane (or in a plan view), the first organic layer opening OP-e1 may be located inside a first line portion P1. When viewed in the plane (or in a plan view), the first organic layer opening OP-e1 may surround a portion of an area where a contact hole CNT is located. When viewed in the plane (or in a plan view), the first organic layer opening OP-e1 may not overlap the area where the contact hole CNT is located. When viewed in the plane (or in a plan view), as the first organic layer opening OP-e1 surrounds only the portion of the area where the contact hole CNT is located, a gas generated from the organic layer 60 may be discharged. That is, the organic layer 60 may be provided in a single unitary form without being divided into portions by the first organic layer opening OP-e1.

The second line portion P2 may be located directly on a portion of the organic layer 60 where the contact hole CNT is located. The second line portion P2 may be located directly on the connection portion CP exposed through the first organic layer opening OP-e1. As the second line portion P2 may be located directly on the connection portion CP exposed through the first organic layer opening OP-e1, the connection portion CP may be electrically connected to the second line portion P2.

When viewed in the plane (or in a plan view), the second organic layer opening OP-e2 may be located outside the first line portion P1. However, different from this structure, the second organic layer opening OP-e2 may be located inside the first line portion P1. The second organic layer opening OP-e2 may not overlap the area where the contact hole CNT is located. The connection portion CP may be exposed through the second organic layer opening OP-e2, and the exposed connection portion CP may be covered by the second line portion P2. The connection portion CP and the second line portion P2, which are located in the second organic layer opening OP-e2, may include portions that are in contact with each other in a flat shape.

Although aspects of some embodiments of the present invention have been described, it is understood that the present invention should not be limited to these embodiments but various changes and modifications can be made by one ordinary skilled in the art within the scope of embodiments according to the present invention as defined in the appended claims. Therefore, the disclosed subject matter should not be limited to any single embodiment described herein.

## Claims

1. A display device (DD), especially of an electronic device, comprising:
a base substrate comprising a first area (NBA1), a second area (NBA2) spaced apart from the first area (NBA1) in a first direction (DR1), and a third area (BA) between the first area (NBA1) and the second area (NBA2);
a pixel (PX) in the first area (NBA1); and
a signal line (SL) in the first, second, and third areas (NBA1, NBA2, BA), the signal line (SL) comprising:
a first line portion (P1) in the first area (NBA1);
an insulating layer (INS) on the first line portion (P1) and having a plurality of contact holes (CNT) defined therethrough;
a connection portion (CP) on the insulating layer (INS) and connected to the first line portion (P1) via the contact holes (CNT); and
a second line portion (P2) extending from the first area (NBA1) to the third area (BA) and on a different layer from the first line portion (P1),
wherein the contact holes (CNT) are covered by the second line portion (P2) and overlap the second line portion (P2) in a plan view.

2. The display device (DD) of claim 1, wherein the contact holes (CNT) overlap the first line portion (P1), the connection portion (CP), and the second line portion (P2) in the plan view.

3. The display device (DD) of claim 1 or 2, wherein the display device (DD) further comprises an organic layer (60) between the connection portion (CP) and the second line portion (P2),
the organic layer (60) has a first organic layer opening (OP-a, OP-b1, OP-c1, OP-d1, OP-e1) through which the connection portion (CP) is exposed, and
the second line portion (P2) is directly on an upper surface of the connection portion (CP) exposed through the first organic layer opening (OP-a, OP-b1, OP-c1, OP-d1, OP-e1).

4. The display device (DD) of claim 3, wherein the first organic layer opening (OP-a) overlaps all the contact holes (CNT) in the plan view, and
the first organic layer opening (OP-a) is inside the connection portion (CP) and extends to an area where the first line portion (P1) is not located in the plan view.

5. The display device (DD) of claim 3, wherein the first organic layer opening (OP-b1) does not overlap all the contact holes (CNT) or does not overlap any of the contact holes (CNT) in the plan view, and
the first organic layer opening (OP-b1) surrounds an area where the contact holes (CNT) are located in the plan view.

6. The display device (DD) of claim 3, wherein the first organic layer opening (OP-c1, OP-d1) overlaps some of the contact holes (CNT) in the plan view.

7. The display device (DD) of claim 3, wherein the first organic layer opening (OP-e1) does not overlap all the contact holes (CNT) or does not overlap any of the contact holes (CNT) in the plan view,
the organic layer (60) comprises a first portion that overlaps the contact holes (CNT) and a second portion that overlaps the connection portion (CP) and does not overlap the first line portion (P1), and
the first portion and the second portion of the organic layer (60) are provided integrally with each other.

8. The display device (DD) of claim 3 or one of claims 5 to 7, wherein the first organic layer opening (OP-b1, OP-c1, OP-d1, OP-e1) is inside the connection portion (CP) and the first line portion (P1) in the plan view.

9. The display device (DD) of claim 3 or one of claims 5 to 8, wherein the organic layer (60) further has a second organic layer opening (OP-b2, OP-c2, OP-d2, OP-e2) defined therethrough to be spaced apart from the first organic layer opening (OP-b1, OP-c1, OP-d1, OP-e1) and not to overlap the first line portion (P1).

10. The display device (DD) of claim 9, wherein the second organic layer opening (OP-b2, OP-c2, OP-d2, OP-e2) is inside the connection portion (CP) and the second line portion (P2) in the plan view.

11. The display device (DD) of at least one of claims 1 to 10, wherein the first line portion (P1) comprises molybdenum, Mo.

12. The display device (DD) of at least one of claims 1 to 11, wherein the connection portion (CP) comprises aluminum, Al.

13. The display device (DD) of at least one of claims 1 to 12, wherein the first area (NBA1) comprises a display area (DA) in which the pixel (PX) is located and a first non-display area (NDA) adjacent to the display area (DA), and
the first line portion (P1) is in the first non-display area (NDA).

14. The display device (DD) of at least one of claims 1 to 13, wherein the second area (NBA2) comprises a pad (DP-PD), and
the second line portion (P2) is connected to the pad (DP-PD).

15. The display device (DD) of at least one of claims 1 to 14, wherein the third area (BA) is bent with respect to an imaginary axis (BX) extending in a second direction (DR2) intersecting the first direction (DR1).
